# EUROPÄISCHE PATENTSCHRIFT

(11) **EP 2 492 957 B1**
(45) Veröffentlichungstag und Bekanntmachung des Hinweises auf die Patenterteilung: **11.09.2013**
(21) Anmeldenummer: 12150873.3
(22) Anmeldetag: 12.01.2012
(51) Int. Cl.: H01L 23/24, H01L 25/07

(54) **Schaltungsanordnung**
Switching assembly
Agencement de circuit

(30) Priorität: 22.02.2011 DE 102011004544
(43) Veröffentlichungstag der Anmeldung: 29.08.2012
(73) Patentinhaber: SEMIKRON Elektronik GmbH & Co. KG, 90431 Nürnberg (DE)
(72) Erfinder: Olbrich, Oliver, 90431 Nürnberg (DE); Gruber, Markus, 90518 Altdorf (DE); Lederer, Marco, 90453 Nürnberg (DE); Popp, Rainer, 91580 Petersaurach (DE)

(56) Entgegenhaltungen:
- JP-A- 1 044 051
- US-B1- 6 737 755
- "METHOD TO SHIELD THE EXPOSED SITES NEAR A CHIP DURING ENCAPSULATIONOF C-4 CHIP JOINTS IN A SECOND LEVEL PACKAGING ASSEMBLY", IBM TECHNICAL DISCLOSURE BULLETIN, INTERNATIONAL BUSINESS MACHINES CORP. (THORNWOOD), US, Bd. 33, Nr. 7, 1. Dezember 1990 (1990-12-01), Seite 477/478, XP000108531, ISSN: 0018-8689

## Beschreibung

Die Erfindung betrifft eine Schaltungsanordnung mit einem Isolierstoffkörper, der an einer Hauptfläche eine schaltstrukturierte Metallschicht und mindestens ein hierauf angebrachtes Leistungshalbleiterbauelement aufweist, und mit einer auf dem Isolierstoffkörper angebrachten, der Kontur des Isolierstoffkörpers mit dem hierauf angebrachten mindestens einen Leistungshalbleiterbauelement folgenden Lage einer Isolationsmasse.

Eine derartige Schaltungsanordnung ist aus der DE 10 2004 021 927 B4 bekannt. Bei der Isolationsmasse dieser bekannten Schaltungsanordnung handelt es sich um eine zähflüssige dielektrische Isolationsmasse, wobei nach dem Aufbringen der zähflüssigen dielektrischen Isolationsmasse eine Vernetzung derselben eingeleitet wird. Anschließend erfolgt eine Drehung des Isolierstoffkörpers um eine zu seiner Hochachse senkrechte Achse, so dass die zähflüssige dielektrische Isolationsmasse die von Bonddrahtverbindungen gebildeten schaltungsgerechten Verbindungen des mindestens einen Leistungshalbleiterbauelementes umschließt und überschüssige zähflüssige Isolationsmasse gravitationsbedingt vom Isolierstoffkörper abtropft. Der mit der Isolationsmasse-Lage versehene Isolierstoffkörper wird in einem Gehäuse angeordnet, wonach eine vollständige Vernetzung der dielektrischen Isolationsmasse erfolgt, wodurch sich zwischen dem Gehäuse und dem Isolierstoffkörper eine Klebeverbindung ergibt.

Bei dieser bekannten Schaltungsanordnung ist nicht zuverlässig zu vermeiden, dass die zähflüssige dielektrische Isolationsmasse insbesondere während der Drehung des Isolierstoffkörpers über dessen Rand abfließt. Außerdem kann es durch den sogenannten "Pumpeffekt" zwischen der Isolationsmasse-Lage und dem Gehäuse zu einem Loslösen der Isolationsmasse vom Isolierstoffkörper kommen, so dass die Isolationsabdeckung unterbrochen wird. Daraus resultieren IsolationsSchwachstellen, die im Extremfall zu einem Ausfall der Schaltungsanordnung führen können.

Der Erfindung liegt die Aufgabe zugrunde, eine Schaltungsanordnung der eingangs genannten Art zu schaffen, wobei eine unerwünschte Unterbrechung der Isolationsabdeckung auf einfache Weise verhindert wird.

Diese Aufgabe wird erfindungsgemäß durch die Merkmale des Anspruches 1, d.h. dadurch gelöst, dass entlang des Randbereiches der die schaltstrukturierte Metallschicht aufweisenden Hauptfläche des Isolierstoffkörpers ein vom Rand der schaltstrukturierten Metallschicht durch einen Graben beabstandeter Metallschichtrahmen umläuft, und dass ein Dammwulst aus einem Vergußmaterial oder einem dem Vergußmaterial ähnlichen Material mit höherer Viskosität den umlaufenden Graben teilweise oder bevorzugt vollständig ausfüllt, wobei der Dammwulst sich zwischen dem Metallschichtrahmen und dem Rand der schaltstrukturierten Metallschicht erstreckt und zur Begrenzung der Lage aus der Isolationsmasse vorgesehen ist.

Durch den Graben, der einerseits durch den Rand der schaltstrukturierten Metallschicht und andererseits durch den umlaufenden Metallschichtrahmen begrenzt ist, wird dem Vergußmaterial für den Dammwulst ein definierter Raum auf dem Isolierstoffkörper geboten, d.h. eine sichere Positionierung des Dammwulst-Vergußmaterials gewährleistet, so dass das Vergußmaterial für den Dammwulst nicht über den umlaufenden Rand des Isolierstoffkörpers ungewollt abtropft. Die Isolationsmasse-Lage wird mittels des Dammwulstes definiert begrenzt und an einem Abtropfen über den Rand des Isolierstoffkörpers gehindert. Ein unerwünschtes Loslösen der Isolationsmasse-Lage wird erfindungsgemäß verhindert, so dass eine Unterbrechung der Isolationsabdeckung, die zu Isolationsschwachstellen und im Extremfall zu einem Ausfall der Schaltungsanordnung führen würde, auf einfache Weise vermieden wird.

Die schaltstrukturierte Metallschicht und der Metallschichtrahmen bestehen vorzugsweise aus demselben Metall, bspw. aus Kupfer, oder aus derselben Metalllegierung. Der Isolierstoffkörper besteht bspw. aus einer Industriekeramik wie Al₂O₃ o.dgl.

Der den Metallschichtrahmen vom Rand der benachbarten schaltstrukturierten Metallschicht beabstandende Graben erstreckt sich vorzugsweise bis zur zugehörigen Hauptfläche des Isolierstoffkörpers, er wird bspw. durch Ätzen der an der entsprechenden Hauptfläche des Isolierstoffkörpers vorgesehenen Metallschicht - gleichzeitig mit der Schaltstrukturierung derselben - realisiert.

Damit der zwischen dem Metallschichtrahmen und dem Rand der schaltstrukturierten Metallschicht vorhanden Dammwulst weiter verbessert auf dem Isolierstoffkörper fixiert wird, kann es vorteilhaft sein, wenn der Metallschichtrahmen in seiner Längserstreckung mit voneinander beabstandeten Vertiefungen ausgebildet ist. Die Vertiefungen können wie der oben erwähnte Graben durch Ätzen - gleichzeitig mit der Herstellung des Grabens - hergestellt werden.

Der Metallschichtrahmen kann sich bis zum umlaufenden Rand des Isolierstoffkörpers erstrecken oder vom Rand des Isolierstoffkörpers einen definierten Abstand aufweisen, um ein Gehäuse der Schaltungsanordnung mittels des Dammwulstes mit dem Isolierstoffkörper zu verkleben oder den umlaufenden Dammwulst vom Gehäuse der Schaltungsanordnung definiert zu beabstanden.

Aus der DE 10 2008 26 347 A1 ist zwar eine Schaltungsanordnung mit einem Isolierstoffkörper bekannt, der an einer Hauptfläche eine schaltstrukturierte Metallschicht aufweist, die gegenüber einem Grundkörper ein hohes elektrisches Potential besitzt, und deren Rand vom Rand des Isolierstoffkörpers beabstandet ist, wobei im Randbereich zwischen dem Rand der schaltstrukturierten Metallschicht und dem Rand des Isolierstoffkörpers voneinander beabstandete Metallschichtrahmen vorgesehen sind. Der randseitig äußerste Metallschichtrahmen ist mit dem Grundkörper elektrisch leitend verbunden, um die Durchschlagfestigkeit der Schaltungsanordnung am Randbereich des Isolierstoffkörpers unabhängig von der Art des Isolierstoffkörpers zu erhöhen. Dieser Gesichtspunkt hat mit der vorliegenden Erfindung jedoch keine Gemeinsamkeiten.

Der Dammwulst wird auf den Isolierstoffkörper üblicherweise mittels einer Düseneinrichtung aufgebracht. Im Bereich der jeweiligen Ecke des Isolierstoffkörpers wird die Düseneinrichtung aus produktionstechnischen Gründen, d.h. aus Produktivitäts-Gründen jedoch nicht angehalten, um eine Umstellung der Düseneinrichtung von der einen Raumrichtung in die dazu senkrechte Raumrichtung zu bewirken, sondern die Düseneinrichtung bewegt sich im jeweiligen Eckenbereich des Isolierstoffkörpers entlang einer abgerundeten Bahn mit einem kleinen Krümmungsradius. Ist der Rand der schaltstrukturierten Metallschicht der Schaltungsanordnung im Bereich der jeweiligen Ecke des Isolierstoffkörpers jedoch mit einer scharfkantig rechtwinkeligen Ecke ausgebildet, so resultiert aus dem dort abgerundeten Verlauf des Dammwulstes eine Reduktion des Isolationsabstandes zwischen der Ecke der schaltstrukturierten Metallschicht und dem Außenrand des Dammwulstes. Diese Reduktion des Isolationsabstandes kann sich auf die Isolationsfestigkeit nachteilig auswirken. Um das zu vermeiden, hat es sich als zweckmäßig erwiesen, wenn der Dammwulst im jeweiligen Eckenbereich des Isolierstoffkörpers abgerundet verläuft, und der Rand der schaltstrukturierten Metallschicht im jeweiligen Eckenbereich der schaltstrukturierten Metallschicht mit einer Abrundung oder mit einer Abfasung ausgebildet ist. Dabei ist es vorteilhaft, wenn die Abrundung oder die Abfasung des Randes der schaltstrukturierten Metallschicht an die im jeweiligen Eckenbereich des Isolierstoffkörpers ausgebildete Abrundung des Dammwulstes angepaßt ist.

Besonders vorteilhaft ist es, wenn der Dammwulst im jeweiligen Eckenbereich des Isolierstoffkörpers abgerundet verläuft, und wenn der Metallschichtrahmen einen Innenrand aufweist, der im jeweiligen Eckenbereich des Isolierstoffkörpers mit einer Abrundung oder mit einer Abfasung ausgebildet ist. Bei einer solchen Ausbildung der zuletzt genannten Art ist es bevorzugt, wenn die Abrundung oder die Abfasung des Innenrandes des Metallschichtrahmens an die im jeweiligen Eckenbereich des Isolierstoffkörpers ausgebildete Abrundung des Dammwulstes angepaßt ist.

Ebenfalls eine ähnliche Schaltungsanordnung zeigt die Druckschrift US 6,737,755 B1.

Weitere Einzelheiten, Merkmale und Vorteile ergeben sich aus der nachfolgenden Beschreibung eines in der Zeichnung schematisch dargestellten Ausführungsbeispieles der erfindungsgemäßen Schaltungsanordnung.

Es zeigen:
Figur 1 eine schematische Schnittdarstellung der Schaltungsanordnung in einem vergrößerten Maßstab,
Figur 2 das Detail II gemäß Figur 1 in einem weiter vergrößerten Maßstab,
Figur 3 das Detail III gemäß Figur 1 in einem der Figur 2 ähnlichen vergrößerten Maßstab,
Figur 4 abschnittweise in einem vergrößerten Maßstab eine Darstellung des Metallschichtrahmens - zur Verdeutlichung von Vertiefungen - in einer Ansicht von oben,
Figur 5 abschnittweise vergrößert einen Eckenbereich des Isolierstoffkörpers zur Verdeutlichung der Problematik eines in dem besagten Eckenbereich abgerundet verlaufenden Dammwulstes,
Figur 6 eine der Figur 5 ähnliche schematische Darstellung eines Eckenbereiches des Isolierstoffkörpers mit dort abgerundet verlaufendem Dammwulst und einer Abrundung des Randes der schaltstrukturierten Metallschicht in diesem Eckenbereich,
Figur 7 eine der Figur 6 ähnliche Darstellung mit einer Abfasung des Randes der schaltstrukturierten Metallschicht im Eckenbereich des Isolierstoffkörpers,
Figur 8 eine der Figur 6 prinzipiell ähnliche Darstellung mit einem Metallschichtrahmen, dessen Innenrand im entsprechenden Eckenbereich des Isolierstoffkörpers mit einer Abrundung ausgebildet ist, und
Figur 9 eine der Figur 7 prinzipiell ähnliche Darstellung zur Verdeutlichung eines Metallschichtrahmens, dessen Innenrand im jeweiligen Eckenbereich des Isolierstoffkörpers mit einer Abfasung ausgebildet ist.

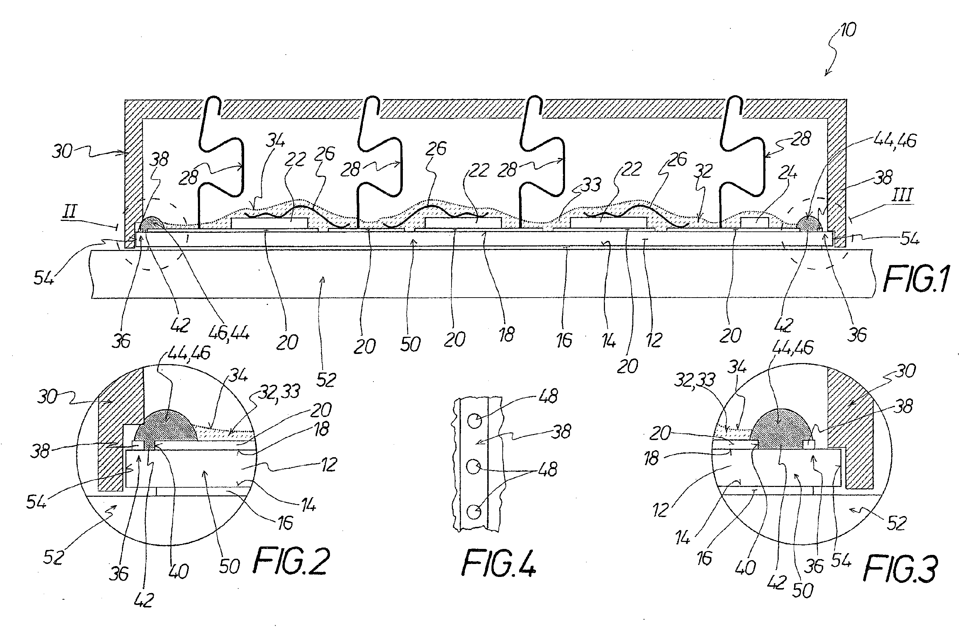

Figur 1 zeigt eine Ausbildung der Schaltungsanordnung 10 mit einem Isolierstoffkörper 12, der an einer Hauptfläche 14 eine Metallschicht 16 aufweist. Die Metallschicht 16 ist an der Hauptfläche 14 vollflächig vorgesehen. An der von der Hauptfläche 14 abgewandten Hauptfläche 18 des Isolierstoffkörpers 12 ist zur Ausbildung von Leiterbahnen eine schaltstrukturierte Metallschicht 20 vorgesehen. An der schaltstrukturierten Metallschicht 20 sind Leistungshalbleiterbauelemente 22 wie Dioden, Thyristoren, IGBTs und/oder MOS-FETs sowie Sensorbauelemente 24 vorgesehen. Die Leistungshalbleiterbauelemente 22 sind mit der schaltstrukturierten Metallschicht 20 mittels Drahtbondverbindungen 26 zusammengeschaltet.

Mit der Bezugsziffer 28 sind Kontaktfedern bezeichnet, die zur elektrischen Verbindung der Leiterbahnen bildenden schaltstrukturierten Metallschicht 20 mit (nicht gezeichneten) externen Zuleitungen dienen. Zu diesem Zwecke erstrecken sich die Kontaktfedern 28 geringfügig aus einem Gehäuse 30 der Schaltungsanordnung 10 heraus. Selbstverständlich sind die dargestellten Kontaktfedern nur eine mögliche Ausgestaltung derartiger Anschlusselementen.

Auf dem Isolierstoffkörper 12 ist eine Lage 32 aus einer Isolationsmasse 33 angebracht, wobei die Oberflächen-Kontur 34 der Lage 32 den Leistungshalbleiterbauelementen 22 folgt und die Isolationsmasse 33 die Drahtbondverbindungen 26 umschließt.

Wie auch aus den Figuren 2 und 3 ersichtlich ist, läuft entlang des Randbereiches der die schaltstrukturierte Metallschicht 20 aufweisenden Hauptfläche 18 des Isolierstoffkörpers 12 ein Metallschichtrahmen 38 um. Der Metallschichtrahmen 38 ist vom Rand 40 der schaltstrukturierten Metallschicht 20 durch einen Graben 42 beabstandet, der zur definierten Positionierung eines Dammwulstes 44 vorgesehen ist. Der Dammwulst 44 besteht aus einem Vergußmaterial 46, er dient zur randseitigen Begrenzung der Isolationsmasse 33 der Lage 32, er erstreckt sich zwischen dem Metallschichtrahmen 38 und dem Rand 40 der schaltstrukturierten Metallschicht 20, d.h. vom Metallschichtrahmen 38 bis zur schaltstrukturierten Metallschicht 20.

Zur weiter verbesserten Fixierung des Vergußmaterials 46 des Dammwulstes 44 kann der Metallschichtrahmen 38 in seiner Längserstreckung mit voneinander beabstandeten Vertiefungen 48 (siehe Figur 4) ausgebildet sein.

Die Leiterbahnen bildende, schaltstrukturierte Metallschicht 20 und der randseitig um den Isolierstoffkörper 12 umlaufende Metallschichtrahmen 38 bestehen vorzugsweise aus demselben Metall, bspw. aus Kupfer. Der umlaufende Graben 42 für den Dammwulst 44 kann durch Ätzen hergestellt werden, wobei sich der Graben 42 bis zur zugehörigen Hauptfläche 18 des Isolierstoffkörpers 12 erstreckt. Gleichzeitig mit der Herstellung des umlaufenden Grabens 42 können im Metallschichtrahmen 38 auch die Vertiefungen 48 z.B. durch Ätzen hergestellt werden.

Figur 2 verdeutlicht eine Ausbildungsvariante, wobei das Gehäuse 30 mittels des Vergußmaterials 46 des Dammwulstes 44 mit dem vom Isolierstoffkörper 12, der vollflächigen Metallschicht 16 und der schaltstrukturierten Metallschicht 20 gebildeten Substrat 50 fest verbunden ist. Demgegenüber verdeutlicht die Figur 3 eine Ausbildung der Schaltungsanordnung 10, bei welcher das Gehäuse 30 vom Dammwulst 44 beabstandet ist und auf eine andere an sich bekannte Weise mit einem Grundkörper 52, bei dem es sich bspw. um einen Kühlkörper handelt, mechanisch fest verbunden sein kann. Bei der Ausbildung gemäß Figur 2 befindet sich der umlaufende Metallschichtrahmen 38 in unmittelbarer Nähe des umlaufenden Randes 54 des Isolierstoffkörpers 12 des Substrates 50. Demgegenüber verdeutlicht die Figur 3 eine Ausbildung, bei welcher der Metallschichtrahmen 38 vom Rand 54 des Isolierstoffkörpers 12 definiert beabstandet ist, um den Dammwulst 44 vom Gehäuse 30 der Schaltungsanordnung zu beabstanden.

Gleiche Einzelheiten sind in den Figuren 1 bis 4 jeweils mit denselben Bezugsziffern bezeichnet, so dass es sich erübrigt, in Verbindung mit diesen Figuren alle Einzelheiten jeweils detailliert zu beschreiben.

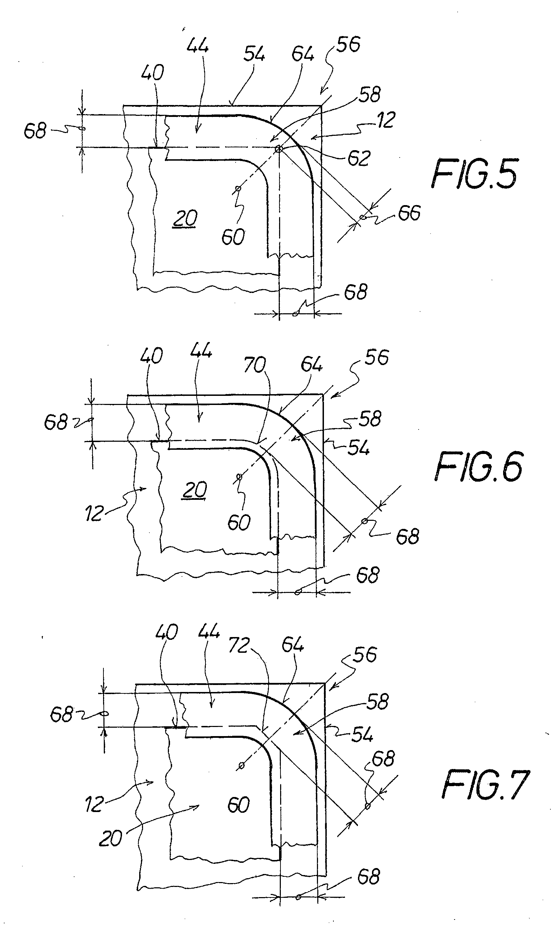

Figur 5 verdeutlicht abschnittweise einen Eckenbereich 56 des Isolierstoffkörpers 12. Mit der Bezugsziffer 44 ist der Dammwulst bezeichnet, der im Eckenbereich 56 mit einer Abrundung 58 ausgebildet ist, um den Dammwulst mit Hilfe einer (nicht gezeichneten) Düseneinrichtung zeitsparend herstellen zu können. Die Abrundung 58 des Dammwulstes 44 weist einen Krümmungsmittelpunkt 60 auf.

Ist der Rand 40 der schaltstrukturierten Metallschicht 20 im Eckenbereich 56 des Isolierstoffkörpers 12 mit einer Ecke 62 ausgebildet, so ergibt sich zwischen dem Außenrand 64 des Dammwulstes 44 und der Ecken 62 der schaltstrukturierten Metallschicht 20 an der jeweiligen Abrundung 58 eine Reduktion des Isolierabstandes, die durch den Doppelpfeil 66 verdeutlicht ist. Entlang den zueinander senkrecht orientierten, geradlinig verlaufenden Abschnitten weist der Dammwulst 44 demgegenüber einen Isolationsabstand auf, der durch den Doppelpfeil 68 verdeutlicht ist.

Um eine solche Reduktion des Isolationsabstandes im jeweiligen Eckenbereich 56 des Isolierstoffkörpers 12 zu vermeiden, kann der Rand 40 der schaltstrukturierten Metallschicht 20 im jeweiligen Eckenbereich 56 mit einer Abrundung 70, wie sie in Figur 6 dargestellt ist, oder mit einer Abfasung 72, wie sie in Figur 7 gezeichnet ist, ausgebildet sein.

Gleiche Einzelheiten sind in den Figuren 6 und 7 mit denselben Bezugsziffern wie in Figur 5 bezeichnet, so dass es sich erübrigt, in Verbindung mit den Figuren 6 und 7 alle Einzelheiten noch einmal detailliert zu beschreiben.

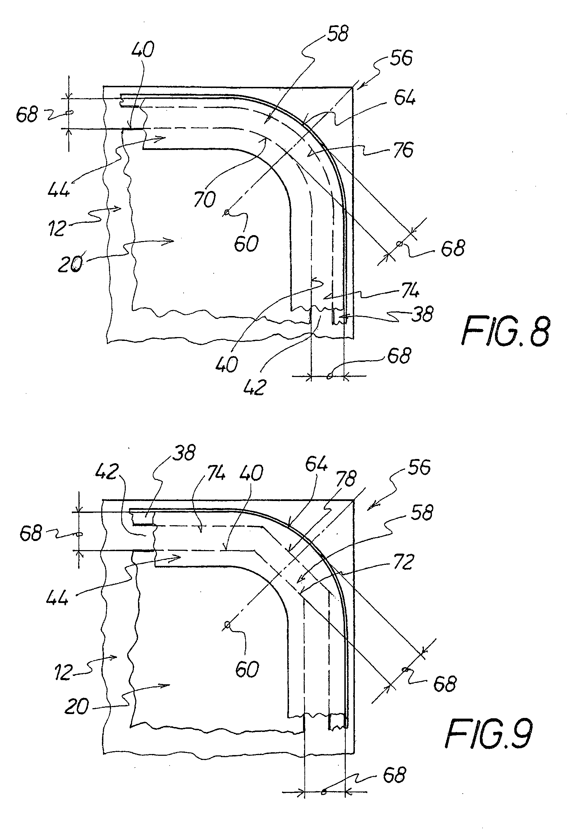

Figur 8 verdeutlicht einen Eckenbereich 56 des Isolierstoffköpers 12, wobei der Graben 42 für den Dammwulst 44 einerseits durch den Rand 40 der schaltstrukturierten Metallschicht 20 und andererseits durch den Metallschichtrahmen begrenzt ist. Bei dieser Ausbildung der Schaltungsanordnung ist der Rand 40 im jeweiligen Eckenbereich 56 mit einer Abrundung 70 und außerdem der Innenrand 74 des Metallschichtrahmens 38 im besagten Eckenbereich 56 mit einer Abrundung 76 ausgebildet. Der Krümmungsmittelpunkt der Abrundung 70 und der Abrundung 76 ist auch in Figur 8 mit der Bezugsziffer 60 - wie in den Figuren 5 und 6 - bezeichnet.

Gleiche Einzelheiten sind in Figur 8 mit denselben Bezugsziffern wie in Figur 6 bezeichnet, so dass es sich erübrigt, in Verbindung mit Figur 8 alle Einzelheiten noch einmal zu beschreiben.

Figur 9 verdeutlicht eine Ausbildung eines Eckenbereiches 56 des Isolierstoffkörpers 12 der Schaltungsanordnung, wobei der Rand 40 der schaltstrukturierten Metallschicht 20 mit einer Abfasung 72 - siehe auch die Figur 7 - ausgebildet ist, und wobei auch der Innenrand 74 des um den Isolierstoffkörper 12 umlaufenden Metallschichtrahmens 38 mit einer zur Abfasung 72 konformen Abfasung 78 ausgebildet ist.

Gleiche Einzelheiten sind in Figur 9 mit denselben Bezugsziffern wie in Figur 7 bezeichnet, so dass es sich erübrigt, in Verbindung mit Figur 9 alle Einzelheiten noch einmal zu beschreiben.

### Bezugsziffernliste:

- 10: Schaltungsanordnung
- 12: Isolierstoffkörper (von 10)
- 14: Hauptfläche (von 12)
- 16: flächige Metallschicht (an 14)
- 18: Hauptfläche (von 12)
- 20: schaltstrukturierte Metallschicht (an 18)
- 22: Leistungshalbleiterbauelement (an 20)
- 24: Sensorbauelement (an 22)
- 26: Drahtbondverbindung (zwischen 22 und 20)
- 28: Kontaktfeder (von 10)
- 30: Gehäuse (von 10)
- 32: Isolationslage (auf 12)
- 33: Isolationsmasse (von 32)
- 34: Oberflächen-Kontur (von 32)
- 36: Randbereich (von 18)
- 38: Metallschichtrahmen (an 36)
- 40: Rand (von 20)
- 42: Graben (zwischen 40 und 38 für 44)
- 44: Dammwulst (für 32)
- 46: Vergußmaterial (von 44)
- 48: Vertiefung (in 38 für 44)
- 50: Substrat (aus 12, 16 und 20)
- 52: Grundkörper (von 10)
- 54: umlaufender Rand (von 12)
- 56: Eckenbereich (von 12)
- 58: Abrundung (von 44)
- 60: Krümmungsmittelpunkt (von 58)
- 62: Ecke (von 40)
- 64: Außenrand (von 44)
- 66: Reduktion des Isolationsabstandes (zwischen 62 und 64 bei 56)
- 68: Isolationsabstand (zwischen 62 und 64)
- 70: Abrundung (von 40 bei 56)
- 72: Abfasung (von 40 bis 56)
- 74: Innenrand (von 38)
- 76: Abrundung (von 74 bei 56)
- 78: Abfasung (von 74 bei 56)

## Patentansprüche

1. Schaltungsanordnung, mit einem Isolierstoffkörper (12), der an einer Hauptfläche (18) eine schaltstrukturierte Metallschicht (20) und mindestens ein hierauf angebrachtes Leistungshalbleiterbauelement (22) aufweist, und mit einer auf dem Isolierstoffkörper (12) angebrachten, der Oberflächen-Kontur des Isolierstoffkörpers (12) mit dem hierauf angebrachten mindestens einen Leistungshalbleiterbauelement (22) folgenden Lage (32) einer Isolationsmasse (33),
**dadurch gekennzeichnet,**
**dass** entlang des Randbereiches (36) der die schaltstrukturierte Metallschicht (20) aufweisenden Hauptfläche (18) des Isolierstoffkörpers (12) ein vom Rand (40) der schaltstrukturierten Metallschicht (20) durch einen Graben (42) beabstandeter Metallschichtrahmen (38) umläuft, und dass ein Dammwulst (44) aus einem Vergußmaterial (46) den umlaufenden Graben (42) ausfüllt, wobei der Dammwulst (44) zur Begrenzung der Lage (32) aus der Isolationsmasse (33) vorgesehen ist und sich zwischen dem Metallschichtrahmen (38) und dem Rand (40) der schaltstrukturierten Metallschicht (20) erstreckt.

2. Schaltungsanordnung nach Anspruch 1,
**dadurch gekennzeichnet,**
**dass** die schaltstrukturierte Metallschicht (20) und der Metallschichtrahmen (38) aus demselben Metall oder derselben Metalllegierung bestehen.

3. Schaltungsanordnung nach Anspruch 1,
**dadurch gekennzeichnet,**
**dass** der den Metallschichtrahmen (38) vom Rand (40) der benachbarten schaltstrukturierten Metallschicht (20) beabstandende Graben (42) sich bis zur zugehörigen Hauptfläche (18) des lsolierstoffkörpers (12) erstreckt.

4. Schaltungsanordnung nach Anspruch 1,
**dadurch gekennzeichnet,**
**dass** der Metallschichtrahmen (38) in seiner Längserstreckung mit voneinander beabstandeten Vertiefungen (48) ausgebildet ist.

5. Schaltungsanordnung nach einem der Ansprüche 1 bis 4,
**dadurch gekennzeichnet,**
**dass** der Metallschichtrahmen (38) am umlaufenden Rand (54) des lsolierstoffkörpers (12) vorgesehen ist oder vom Rand (54) einen Abstand aufweist.

6. Schaltungsanordnung nach einem der Ansprüche 1 bis 5,
**dadurch gekennzeichnet,**
**dass** der Dammwulst (44) im jeweiligen Eckenbereich (56) des Isolierstoffkörpers (12) mit einer Abrundung (58) verläuft und der Rand (40) der schaltstrukturierten Metallschicht (20) im jeweiligen Eckenbereich (56) mit einer Abrundung (70) oder mit einer Abfasung (72) ausgebildet ist.

7. Schaltungsanordnung nach Anspruch 6,
**dadurch gekennzeichnet,**
**dass** die Abrundung (70) oder die Abfasung (72) des Randes (40) der schaltstrukturierten Metallschicht (20) an die im jeweiligen Eckenbereich (56) des Isolierstoffkörpers (12) ausgebildete Abrundung (58) des Dammwulstes (44) angepaßt ist.

8. Schaltungsanordnung nach einem der Ansprüche 1 bis 7,
**dadurch gekennzeichnet,**
**dass** der Dammwulst (44) im jeweiligen Eckenbereich (56) des Isolierstoffkörpers (12) mit einer Abrundung (58) verläuft und der Metallschichtrahmen (38) einen Innenrand (74) aufweist, der im jeweiligen Eckenbereich (56) mit einer Abrundung (76) oder mit einer Abfasung (78) ausgebildet ist.

9. Schaltungsanordnung nach Anspruch 8,
**dadurch gekennzeichnet,**
**dass** die Abrundung (76) oder die Abfasung (78) des Innenrandes (74) des Metallschichtrahmens (38) an die im jeweiligen Eckenbereich (56) des Isolierstoffkörpers (12) ausgebildete Abrundung (58) des Dammwulstes (44) angepaßt ist.

## Claims

1. A circuit arrangement with an insulant body (12), which, on a main surface (18), has a metal layer (20) with circuit structuring and at least one power semiconductor component (22) attached thereon, and with a layer (32) of an insulating compound (33) applied on the insulant body (12) following the surface contour of the insulant body (12) with the at least one power semiconductor component (22) attached hereon,
**characterised**
**in that** a metal layer frame (38), which is spaced from the edge (40) of the metal layer (20) with circuit structuring by means of a trench (42), runs along the edge region (36) of the main surface (18) of the insulant body (12) having the metal layer (20) with circuit structuring, and in that a dam bead (44) made up of a casting material (46) fills the surrounding trench (42), wherein the dam bead (44) is provided for delimiting the layer (32) from the insulating compound (33) and extends between the metal layer frame (38) and the edge (40) of the metal layer (20) with circuit structuring.

2. The circuit arrangement according to Claim 1,
**characterised**
**in that** the metal layer (20) with circuit structuring and the metal layer frame (38) consist of the same metal or the same metal alloy.

3. The circuit arrangement according to Claim 1,
**characterised**
**in that** the trench (42) spacing the metal layer frame (38) from the edge (40) of the adjacent metal layer (20) with circuit structuring extends as far as to the associated main surface (18) of the insulant body (12).

4. The circuit arrangement according to Claim 1,
**characterised**
**in that** the metal layer frame (38) is constructed with mutually spaced depressions (48) in its longitudinal extent.

5. The circuit arrangement according to one of Claims 1 to 4,
**characterised**
**in that** the metal layer frame (38) is provided at the peripheral edge (54) of the insulant body (12) or has a spacing from the edge (54).

6. The circuit arrangement according to one of Claims 1 to 5,
**characterised**
**in that** the dam bead (44) runs in the respective corner region (56) of the insulant body (12) with a chamfer (58) and the edge (40) of the metal layer (20) with circuit structuring is constructed in the respective corner region (56) with a chamfer (70) or with a bevel (72).

7. The circuit arrangement according to Claim 6,
**characterised**
**in that** the chamfer (70) or the bevel (72) of the edge (40) of the metal layer (20) with circuit structuring is adapted to the chamfer (58) of the dam bead (44) in the respective corner region (56) of the insulant body (12).

8. The circuit arrangement according to one of Claims 1 to 7,
**characterised**
**in that** the dam bead (44) runs in the respective corner region (56) of the insulant body (12) with a chamfer (58) and the metal layer frame (38) has an inner edge (74), which is constructed in the respective corner region (56) with a chamfer (76) or with a bevel (78).

9. The circuit arrangement according to Claim 8,
**characterised**
**in that** the chamfer (76) or the bevel (78) of the inner edge (74) of the metal layer frame (38) is adapted to the chamfer (58) of the dam bead (44) in the respective corner region (56) of the insulant body (12).

## Revendications

1. Circuit, avec un corps isolant (12), présentant une couche métallique structurée pour commutation (20) sur une surface principale (18) et au moins un composant semi-conducteur de puissance (22) appliqué sur celle-ci, et avec une couche (32) d'une masse isolante (33) appliquée sur le corps isolant (12), suivant le contour de surface du corps isolant (12) avec l'au moins un composant semi-conducteur de puissance (22) appliqué sur celui-ci,
caractérisé en ce qui :
un cadre (38) de couche métallique espacé par un canal (42) du bord (40) de la couche métallique structurée pour commutation (20) s'étend périphériquement le long de la zone de bord (36) de la surface principale (18) du corps isolant (12) présentant la couche métallique structurée pour commutation (20), et en ce qu'un boudin d'étanchéité (44) en matériau de scellement (46) comble le canal de pourtour (42), ledit boudin d'étanchéité (44) étant prévu pour délimiter la couche (32) en masse isolante (33) et s'étendant entre le cadre (38) de couche métallique et le bord (40) de la couche métallique structurée pour commutation (20).

2. Circuit selon la revendication 1, **caractérisé en ce que** :
la couche métallique structurée pour commutation (20) et le cadre (38) de couche métallique sont constitués du même métal ou du même alliage métallique.

3. Circuit selon la revendication 1, **caractérisé en ce que** :
le canal (42) espaçant le cadre (38) de couche métallique du bord (40) de la couche métallique structurée pour commutation (20) contiguë s'étend jusqu'à la surface principale (18) correspondante du corps isolant (12).

4. Circuit selon la revendication 1, **caractérisé en ce que** :
le cadre (38) de couche métallique est prévu avec des évidements (48) espacés l'un de l'autre dans son extension longitudinale.

5. Circuit selon l'une des revendications 1 à 4, caractérisé en ce qui :
le cadre (38) de couche métallique est prévu contre le bord (54) périphérique du corps isolant (12) ou est espacé du bord (54).

6. Circuit selon l'une des revendications 1 à 5, **caractérisé en ce que** :
le boudin d'étanchéité (44) s'étend avec un arrondi (58) dans chaque zone de coin (56) du corps isolant (12) et le bord (40) de la couche métallique structurée pour commutation (20) est réalisé avec un arrondi (70) ou avec un biseau (72) dans chaque zone de coin (56).

7. Circuit selon la revendication 6, **caractérisé en ce que** :
l'arrondi (70) ou le biseau (72) du bord (40) de la couche métallique structurée pour commutation (20) sont ajustés à l'arrondi (58) du boudin d'étanchéité (44) réalisé dans chaque zone de coin (56) du corps isolant (12).

8. Circuit selon l'une des revendications 1 à 7, **caractérisé en ce que** :
le boudin d'étanchéité (44) s'étend avec un arrondi (58) dans chaque zone de coin (56) du corps isolant (12), et le cadre (38) de couche métallique présente un bord intérieur (74) réalisé avec un arrondi (76) ou avec un biseau (78) dans chaque zone de coin (56).

9. Circuit selon la revendication 8, **caractérisé en ce que** :
l'arrondi (76) ou le biseau (78) du bord intérieur (74) du cadre (38) de couche métallique sont ajustés à l'arrondi (58) du boudin d'étanchéité (44) réalisé dans chaque zone de coin (56) du corps isolant (12).
